Europäisches Patentamt

European Patent Office

Office européen des brevets

(11) Publication number: **0 462 330 A1**

## (12) EUROPEAN PATENT APPLICATION

(21) Application number: 90201630.2

(22) Date of filing: 21.06.90

(51) Int. Cl.5: **G03C 11/12, G03C 1/76**

(43) Date of publication of application:
27.12.91 Bulletin 91/52

(84) Designated Contracting States:
AT BE CH DE DK ES FR GB GR IT LI LU NL SE

(71) Applicant: **AGFA-GEVAERT naamloze vennootschap**
**Septestraat 27**
**B-2510 Mortsel(BE)**

(72) Inventor: **Daems,Eddie Roza**
**Eigenhaard 30**
**B-2200 Herentals(BE)**
Inventor: **Van der Heyden,Jozef August**
**Lodewijk van Berckenlaan 165**
**B-2140 Borgerhout(BE)**
Inventor: **Leenders,Luc Herwig**
**Lichtaartseweg 182**
**B-2200 Herentals(BE)**

(54) **Process and material for protecting images.**

(57) A process for improving the resistance to mechanical damage of an image formed by coloured hydrophilic colloid layer relief parts on a permanent support or of an image present in a hydrophilic colloid layer on a permanent support and controlling the visual appearance of said image which comprises the transfer to said image of layers (i), (ii) and (iii) from a stripping film material consisting of a temporary support coated with a layer assemblage of (i) an undermost 1 to 15 μm thick water-insoluble layer essentially consisting of a nitrocellulose having a substitution degree (DS) in the range of 2 to 2.5, or essentially consisting of a mixture of such a nitrocellulose with an ethyl cellulose having a substitution degree (DS) in the range of 2.2 to 2.6, wherein the weight ratio of the nitrocellulose to the ethyl cellulose is in the range from 60/40 to 95/5,

(ii) a 0.1 to 1.5 μm thick layer of a mixture of gelatin, maleic acid and a nitrocellulose as defined above, wherein the gelatin is present in a weight percentage of at least 40, the maleic acid is present in a weight percentage between 2.5 and 20, and the nitrocellulose is present in a weight percentage between 20 and 40, and

(iii) a 0.1 to 5 μm thick adhesive top layer becoming sticky when moistened with water and containing unhardened gelatin up to at least 25 % by weight and dispersed polymer particles that have a glass transition temperature (Tg) lower than 0 °C and improve the sticking power of layer (iii) towards a moist gelatin layer.

## 1. Field of the Invention

The present invention relates to a process and materials for protecting images formed by or present in a hydrophilic colloid medium wherein the protection of said images is associated with the controlling of their visible appearance.

## 2. Background of the Invention

The visual aspect of images obtained in hydrophilic colloid media such as in a developed and fixed gelatin silver halide emulsion layer is largely affected by background colour and light-reflectance of the support carrying the image layer. Photographs to be inspected by reflection usually have a paper support. The surface structure of the paper and its colour tone largely determine the visual appearance of the image, e.g. its gloss. A glossy appearance adds to the contrast and gives a better rendition of fine detail. Glossy photographic paper as supplied by the manufacturer dries with a shiny surface, which can further be improved by "glazing". For example, a wet print can be glazed by squeegeeing it onto a clean polished surface that optionally is heated. Hot-glazing requires the use of gelatin layers that are hardened otherwise they would melt and stick to the glazing plate.

Normally photographic silver halide emulsion materials have an outermost layer acting as a gloss improving anti-abrasion layer. Known anti-abrasion layers are generally layers of gelatin a few microns thick optionally containing a hardening agent for gelatin such as chrom alum or some colloidal inorganic material such as silica as described e.g. by P. Glafkidés in the book Photographic Chemistry, Vol. I, Fountain Press - London (1985) p. 474 and in French Patent specification No. 1,551,591.

The application of a thin anti-abrasion layer acting also as a gloss improving layer, by coating from a liquid composition requires a cumbersome and sophisticated coating equipment which in practice is only available in factories producing photographic materials. In some cases it is advantageous to have the possibility to determine at the stage of image-processing which appearance a print should have. For example, such is the case when a photographic image is formed on a permanent support by a plurality of superposed hydrophilic colloid patterns representing a multi-colour relief image obtained by wash-off processing of hardening-developed coloured hydrophilic colloid layers.

The production of colour relief images representing linework or halftone multicolour colloid patterns is of interest in the field of design, e.g. in the production of colour decorative patterns, colour wiring and circuit diagrams, cartography, colour proofing and the preparation of transparencies for transmission projection or production of images on a reflective base for overhead projection.

Photographically produced colour proofs are a substitute for multicolour halftone reproductions as are produced by successive printing in registration of images formed by separate standard inks, i.e. magenta, yellow, cyan and black, on a conventional printing press known as "press proofing".

Press proofing for the production of colour proofs by preparing a printing plate and running the plate on the press to produce only a few copies as proof of the quality of the halftone separation transparencies used in the plate production is a very expensive and time consuming procedure and therefore photographic processes not requiring press printing have been developed to obtain a similar result by means of which the appearance of a print obtained from particular colour separation negatives or positives can be judged by the printer and client.

Examples of processes for the production of multicolour relief patterns using the transfer of coloured colloid layers from a temporary support onto a permanent support are described e.g. in US-P 3,642,474, 4,701,401 and 4,710,444.

In such processes the multicolour pattern is formed by superposed relief paterns obtained by wash-off processing of imagewise exposed layers.

When using said processes for the production of multicolour halftone images serving as a pre-press colour proof it is important that the total dot area of the resultant screened images corresponds as close as possible the total dot area of the halftone prints obtained in the actual mechanical printing process. The optical dot area (ODA) is a measure of the total dot area that takes into account both physical and optical dot gain. The optical dot area (ODA) is the total amount of light absorbed by the halftone dot pattern printed on a substrate. It is expressed as the percentage of the substrate that would have to be covered with halftone dots to achieve a certain density, provided there was no dot spread or "gain" and the substrate reflected 100 percent of the light impinged on the surface (ref. the article "Dot Gain: Causes and Cures" - "The Quality Control Scanner" published monthly by Graphic Arts Publishing Co., 3100 Bronson Hill Road, Livonia NY 14487. (1982) Volume 2, Number 9, p. 5).

Dot gain is made up of two components, physical and optical dot gain. Physical dot gain is an actual enlargement of mechanical dot size which occurs during the printing process wherein individual ink dots are spread or expanded on the printing paper.

Optical dot gain results when light penetrates the printing paper in the clear areas, becomes internally scattered therein and partially absorbed in the ink dots making the dots visually appear larger. Optical dot gain can be influenced by changing the paper stock (see the article "Gaining on Dot Gain" by Johan Strashun in Graphic Arts Montly, January 1985, p. 69).

In offset printing the greatest dot gain occurs in the mid tones, i.e. around the 50 percent dot value. Good colour balance is obtained when all colours have equal dot gain.

Published European Patent Application (EP-A) 0 324 192 relates to a process for controlling the visual appearance of an image present on a permanent support in a hydrophilic colloid layer, layer system or relief pattern.

According to an embodiment said process is characterized by the step of transferring a non-photosensitive continuous hydrophilic colloid covering layer from a temporary support onto said permanent support on top of said image after said image has been formed on the permanent support. The transfer proceeds by pre-wetting the permanent support which carries already said image and by contacting it in pre-wetted state with said covering layer that is stripped off from the temporary support to leave said covering layer on said permanent support.

The covering layer contains hardened gelatin applied at a coverage of at most 20 g/m2 and the hardening of the gelatin corresponds with a hardening stemming from the addition of at least 0.001 g of formaldehyde per gram of gelatin.

For obtaining a desired degree of gloss the gelatin of said covering layer is mixed e.g. with poly-N-vinylpyrrolidone, dextran, polyvinyl alcohol, hydroxypropyl cellulose or colloidal silica.

Although for the purpose of controlling the gloss said covering layer is satisfactory it gives no adequate protection against mechanical damage, i.e. abrasion, of the image material.

## 3. Summary of the Invention

It is an object of the present invention to provide a process imparting a desired visual appearance to images formed by or present in hydrophilic colloid media while their resistance to abrasion (scratch resistance) is improved simultaneously by a transparent outermost anti-abrasion layer.

It is a further object of the present invention to provide a sheet or weblike material suited for offering by wet lamination and stripping a gloss-controlling and abrasion resisting layer assemblage on top of an image or images contained in a hydrophilic colloid layer(s) or formed by superposed coloured hydrophilic colloid relief patterns.

Other objects and advantages of the present invention will become clear from the further description.

The present invention provides a process for improving the resistance to mechanical damage of an image formed by coloured hydrophilic colloid layer relief parts on a permanent support or of an image present in a hydrophilic colloid layer on a permanent support and controlling the visual appearance of said image, which comprises the following steps :

(1) providing a stripping film material consisting of a temporary support coated with a layer assemblage of :

(i) an undermost 1 to 15 μm, preferably 5 μm thick, water-insoluble layer essentially consisting of a nitrocellulose having a substitution degree (DS) in the range of 2 to 2.5, or essentially consisting of a mixture of such a nitrocellulose with an ethyl cellulose having a substitution degree (DS) in the range of 2.2 to 2.6, wherein the weight ratio of the nitrocellulose to the ethyl cellulose is in the range from 60/40 to 95/5, preferably in the range of 85/15,

(ii) a 0.1 to 1.5 μm thick layer of a mixture of gelatin, maleic acid and a nitrocellulose as defined hereinbefore, wherein the gelatin is present in a weight percentage of at least 40, the maleic acid is present in a weight percentage between 2.5 and 20, and the nitrocellulose is present in a weight percentage between 20 and 40, and

(iii) a 0.1 to 5 μm thick adhesive top layer becoming sticky when moistened with water and containing unhardened gelatin up to at least 25 % by weight and dispersed polymer particles that have a glass transition temperature (Tg) lower than 0 °C and improve the sticking power of layer (iii) towards a moist gelatin layer,

(2) pre-wetting with water said coloured hydrophilic colloid layer relief parts or said hydrophilic colloid layer containing an image,

(3) laminating the stripping film to the pre-wetted image side by pressing it with said gelatin containing layer (iii) against the coloured hydrophilic colloid layer relief parts or the hydrophilic colloid layer containing an image on their permanent support, and

(4) stripping off the temporary support to leave the assemblage of said layers (i), (ii) and (iii) covering the imaging material on said permanent support, layer (i) forming an outermost anti-abrasion layer.

The above defined layer (i) consisting of or containing a nitrocellulose as defined above provides a very good resistance to abrasion and a high gloss.

Layer (ii) serves as a kind of subbing layer through which layer (i) strongly adheres in wet and dry state to adhesive layer (iii).

4. Detailed description of the drawings

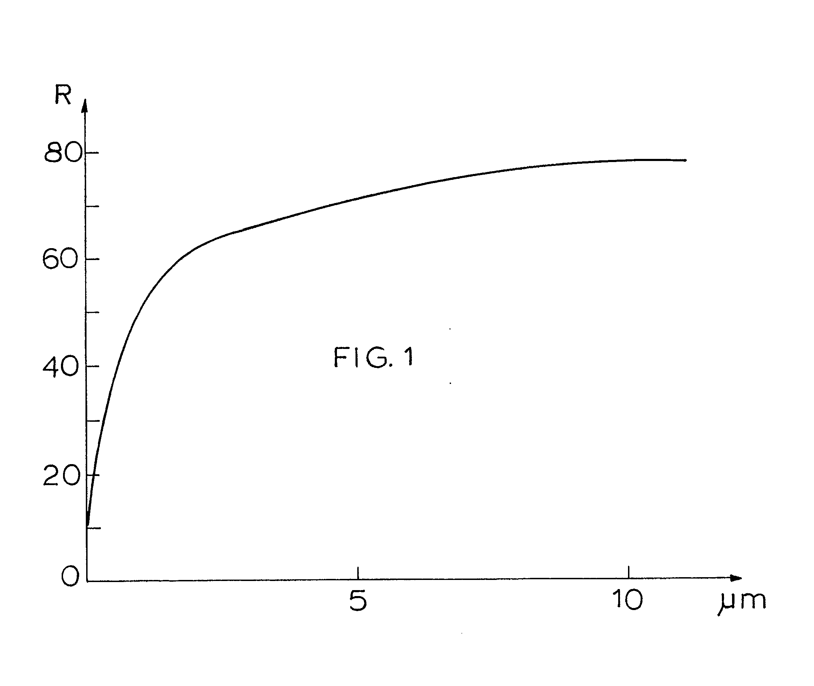

In the accompanying Figure 1 a graph illustrates the percent reflectance (R) measured according to DIN standard No. 67 530 - November 1972, (with measuring angle 20°) as a function of the thickness ($\mu$m) of the anti-abrasion layer (i), the thickness of layers (ii) and (iii) in the layer assemblage being kept constant.

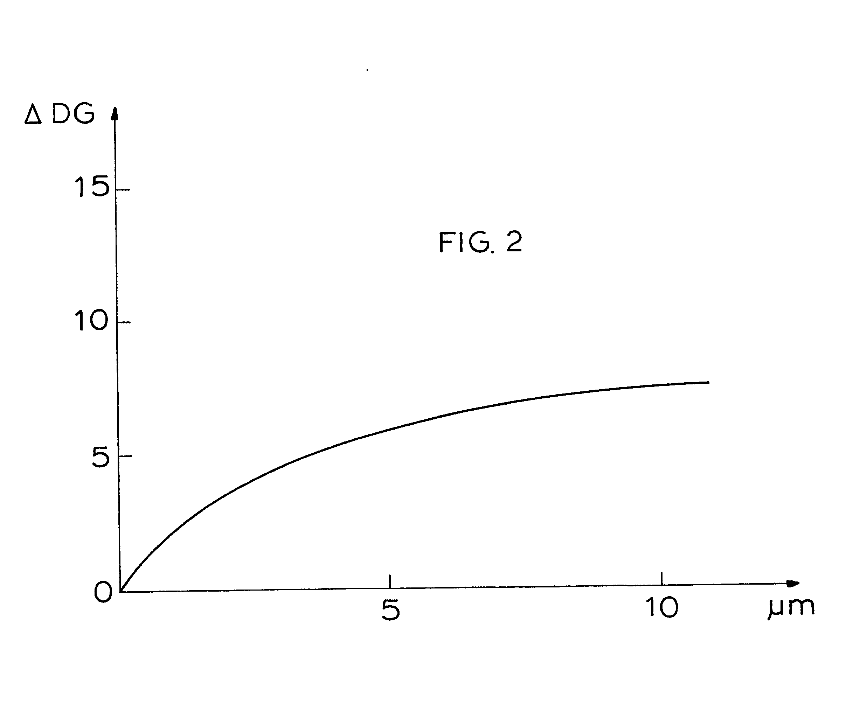

In the accompanying Figure 2 a graph illustrates the increase in dot gain ($\Delta$DG) as a function of the thickness ($\mu$m) of the anti-abrasion layer keeping constant the thickness of the layers (ii) and (iii). The dot gain was measured at 50 percent dot value at 150 lines per 2.54 cm (inch). The determination of dot gain is given at the end of Example 1.

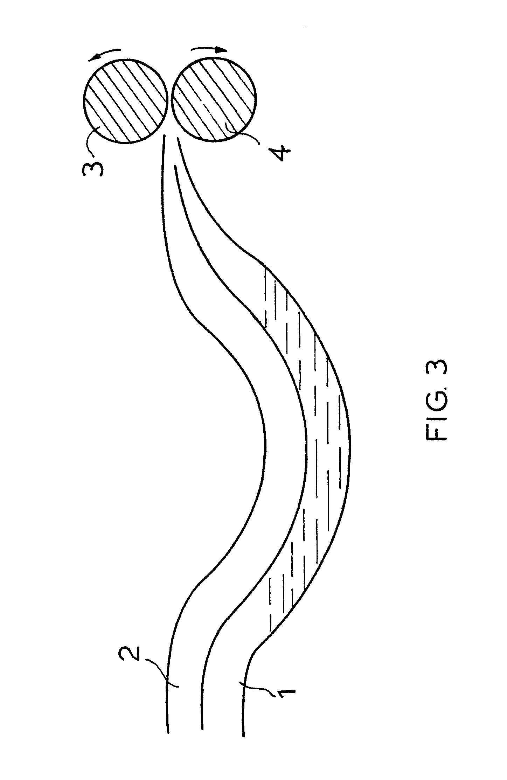

Figure 3 represents a schematic cross-sectional drawing of an apparatus for carrying out the transfer onto image sheet materials of said layer assemblage providing an outermost anti-abrasion layer with gloss improving properties.

5. Detailed description of the Invention

A preferred temporary support of the stripping film material is a cellulose triacetate support.

The sticking power of layer (iii) to wet hydrophilic colloid relief parts or an integral hydrophilic colloid layer is improved substantially by incorporating the dispersed polymer particles having a Tg below 0 °C, preferably below minus 10 °C. Latex particles containing a certain amount of monomer groups having a hydrophilic character are preferred, e.g. free carboxylic acid groups as in a copoly(vinyl acetate-acrylate ester-methacrylic acid) in which the content of methacylic acid units is preferably in the range of 0.5 to 5 mol % and the Tg = -18 °C. Such latex polymer is sold under the registered trade mark DARATAK 74L by GRACE ORGANIC CHEMICAL DIVISION - Lexington, U.S.A.

The gloss of the protected image can be controlled by incorporating a certain amount of matting agent, e.g. in the form of finely divided organic polymer particles and/or inorganic pigment particles, e.g. titanium dioxide particles, in the coating composition of anti-abrasion layer (i).

The colour tone of the image on the permanent support can be controlled by incorporating diffusion-resistant dyes or pigments in layer (i), (ii) and/or (iii), hereby simulating according to one embodiment the somewhat yellowish-brown tone of antique photographs or parchment base documents.

The present process gives very satisfactory results for controlling gloss and improving abrasion resistance of hydrophilic colloid layers of an image that is obtained as superposed hydrophilic coloured colloid relief patterns by wash-off processing of coloured imagewise hardened hydrophilic colloid layers.

According to a preferred embodiment the present process is applied for improving the abrasion resistance, controlling gloss and optical dot area of multicolour halftone images obtained by a wash-off processing.

The production of a multicolour colour proof by wash-off processing proceeds according to a preferred embodiment by the following steps :

(1) transferring a substantially non-hardened gelatin silver halide emulsion layer containing coloured pigment particles dispersed therein from a temporary support onto a permanent support being a paper base support which support may carry already a halftone relief image containing coloured hardened gelatin,

(2) imagewise exposing the non-hardened gelatin silver halide emulsion layer prior to or after carrying out said step (1),

(3) forming by hardening development a halftone image in said transferred silver halide emulsion layer,

(4) removing selectively unhardened portions of the transferred layer by wash-off processing, and

(5) repeating steps (1), (2), (3) and (4) to form at least partly superposed portions of differently coloured gelatin containing layers.

More details about such a process wherein for the formation of a multicolour proof use is made of hardening developed silver halide emulsion layers can be found in US-P 4,701,401 and 4,710,444.

Depending on the use of the multicolour print the permanent support is transparent or opaque and may be made of metal, glass, ceramics, organic resin or paper.

Transparent resin supports can be matted or made opaque in the bulk. The matting may be effected by pigments known therefor in the art, e.g. titanium dioxide, zinc oxide, and barium sulphate. Matting can also be obtained by applying a matting layer or producing a "blushcoat" as described e.g. in United Kingdom Patent Specification 943,681.

For use in colour proofing matted permanent supports can be used as described e.g. in published European Patent Application No. 0 305 599. These supports are paper supports coated with a polyolefin layer and a hardened hydrophilic colloid binder layer containing titanium dioxide pigment particles, which particles have an average grain size in the range of 200 to 450 nm, are present for at most 300 % by weight with respect to the total binder content and are applied at a coverage of at least 0.5 g per m2. By varying the binder/pigment ratio these supports are suited to control the dot gain and to simulate the dot gain in halftone prints obtained by printing with ink on different paper stock. A permanent paper support may be composed of poly-Alpha-olefin coated paper to reduce the take up of moisture and to speed up the drying.

The photosensitive silver halide used in said wash-off image forming process may comprise silver chloride, silver bromide, silver bromoiodide, silver chlorobromoiodide and the like, or mixtures thereof. The silver halide emulsions may be coarse or fine grain and can be prepared by any of the well known procedures, e.g., single jet emulsions, double jet emulsions, such as Lippmann emulsions, ammoniacal emulsions, thiocyanate-or thioether-ripened emulsions such as those described in U.S. Patent Specifications 2,222,264 of Adolph H. Nietz and Frederick J. Russell, issued November 19, 1940, 3,320,069 of Bernard D. Illingsworth, issued May 16, 1967, and 3,271,157 of Clarence E. McBride, issued September 6, 1966. Surface image emulsions may be used or internal image emulsions may be used such as those described in U.S. Patent Specifications 2,592,250 of Edward Philip Davey and Edward Bowes Knott, issued April 8, 1952, 3,206,313 of Henry D. Porter, Thomas H. James and Wesley G. Lowe, issued September 14, 1965, and 3,447,927 of Robert E. Bacon and Jean F.Barbier, issued June 3, 1969. The emulsions may be regular-grain emulsions such as the type described by Klein and Moisar in J. Photogr. Sci., Vol. 12, No. 5, Sept./Oct. 1964, pp. 242-251. If desired, mixtures of surface and internal image emulsions may be used as described in U.S. Patent Specification 2,996,382 of George W. Luckey and John C. Hoppe, issued August 15, 1961.

Apart from negative working silver halide emulsions that are preferred for their high light sensitivity, direct positive silver halide emulsions may be used that produce a positive silver image and a corresponding imagewise distribution of developing agent oxidation products during their development. For example those direct positive silver halide emulsions are considered wherein by exposure or by a chemical treatment a developable fog has been produced, which is destroyed imagewise during the imagewise exposure when certain conditions are fulfilled. In the unexposed areas the fog is maintained so that during the subsequent development a direct positive silver image is obtained and in correspondence therewith an imagewise distribution of oxidized hardening developing agent.

For example, direct positive emulsions of the type described in P.J.Hillson, U.S. Patent 3,062,651, may be utilized to obtain direct positive images. In emulsions of this type, a non-hardening fogging agent such as stannous chloride, formamidine sulfinic acid, or the like is used.

More details about composition, preparation and coating of silver halide emulsions are described, e.g., in Product Licensing Index, Vol. 92, December 1971, publication 9232, p. 107-109 and Research Discl. Nov. (1989) No. 307105, p. 863-885.

The emulsions can be chemically sensitized, e.g. by adding sulphur-containing compounds, e.g. allyl isothiocyanate, allyl thiourea, sodium thiosulphate and the like, during the chemical ripening stage. Also reducing agents, e.g. the tin compounds described in the Belgian Patent Specifications 493,464 and 568,687, and polyamines such as diethylenetriamine or derivatives of aminomethane-sulphonic acid, e.g. according to the Belgian Patent Specification 547,323, can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Hiss. Photogr. Photophys. Photochem. 46, 65-72 (1951).

Further it is possible to sensitize the emulsions with polyalkylene oxide derivatives, e.g. with polyethylene oxide having a molecular weight between 1000 and 20,000, or with condensation products of alkylene oxides and aliphatic alcohols, glycols, cyclic dehydration products of hexitols, alkylsubstituted phenols, aliphatic carboxylic acids, aliphatic amines, aliphatic diamines and amides. The condensation products have a molecular weight of at least 700, preferably of more than 1000. For obtaining special effects these sensitizers of course can be combined with each other as described in Belgian Patent Specification 537,278 filed April 12, 1955 and UK Patent Specification 727,982.

The spectral photosensitivity of the silver halide has to comply with the spectral composition of the exposure light used in the exposure. For a proper spectral sensitization the usual mono- or polymethine dyes such as acidic or basic cyanines, hemicyanines, oxonols, hemioxonols, styryl dyes or others, also tri- or polynuclear methine dyes, e.g. rhodacyanines or neocyanines may be used. Such spectral sensitizers are described, e.g., by F.M.HAMER in "The Cyanine Dyes and Related Compunds" (1964) Interscience Publishers, John Wiley & Sons, New York.

The silver halide emulsions may contain the usual stabilizers, e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxyl or amino groups. Compounds of this kind are described by BIRR in Z. Wiss. Photogr. Photophys. Photochem. 47,, 2-27 (1952). Still other suitable stabilizers are amongst others heterocyclic mercapto compounds, e.g. phenylmercaptotetrazole, quaternary benzothiazole derivatives, benzotriazole and the like.

The hardening development proceeds with commonly used hardening developing agents, also called tanning developing agents for effecting the development of the silver halide and producing oxidized developing agent acting as hardening agent for the hydrophilic colloid binder such as gelatin. Examples of suitable hardening developing agents are : 1,4-dihydroxy benzene compounds such as hydroquinone, chlorohydroquinone, bromohydroquinone, toluhydroquinone, morpholinemethyl hydroquinone, sulfohydroquinone and the like.

The developing agent may be incorporated in an aqueous alkaline processing liquid. When incorporated in the silver halide emulsion layer, and/or in a non-silver halide containing layer adjacent thereto the development can be obtained by applying an alkaline aqueous activator liquid originally free from developing agent.

According to a special embodiment said silver halide emulsion layer is combined with an underlying additional hardenable hydrophilic colloid layer containing an auxiliary developing agent forming a superadditive developing system with the hardening developing agent contained in the coloured silver halide emulsion layer.

Typical activator baths for a hardening developable photographic silver halide emulsion material comprise, for example, an aqueous solution of an alkaline material, such as sodium carbonate, sodium hydroxide, potassium carbonate, potassium hydroxide, mixtures of sodium hydroxide and sodium sulfite, hydroxyalkylamines, e.g. triethanolamine, etc. A suitable activator bath comprises e.g. about 2 percent by weight of sodium hydroxide and 0.5 percent by weight of sodium sulfite.

It will be appreciated that an auxiliary developing agent can be used along with a hydroquinone developing agent in order to improve the speed without disadvantageously affecting the wash-off processing of the invention. Typical auxiliary developing agents include 3-pyrazolidinone developing agents, e.g. 1-phenyl-3-pyrazolidinone, 1-phenyl-4,4-dimethyl-3-pyrazolidinone, 1-phenyl-4-methyl-4'-hydroxymethyl-3-pyrazolidinone and N-methyl-p-aminophenol sulphate.

Said auxiliary developing agents or a mixture thereof may be incorporated in the photographic material and/or in the developing liquid in which the hardening developing agent may be absent when using an alkaline activator bath.

A detailed description is hereinafter set forth of a composition and structure of a light-sensitive material and its use in the production of a multicolour image according to an embodiment of the present invention.

The production of multicolour images by wash-off processing, their protection, the control of their gloss and dot gain according to the present invention is illustrated in more details in the following example. The percentages and ratios are by weight if not otherwise indicated.

EXAMPLE

- Preparation of photographic materials on temporary support.

On a temporary support of unsubbed cellulose triacetate provided at the rear side with a black antihalation layer and having a thickness of 0.1 mm the following layers were applied in the order given :

(1) a silver chlorobromide-iodide emulsion (molar ratio 83.6/16/0.4) containing diffusion-resistant cyan coloured pigment and having a silver halide coverage equivalent with 0.25 g of silver per sq.m. and gelatin coverage of 1.8 g per sq.m. The emulsion was spectrally sensitized for argon ion laser light. The cyan pigment was FLEXONYL BLUE Paste (C.I. Index Nr. 74,160) which was applied at 6.3 g per liter of coating composition corresponding with 0.126 g of pigment solid per m2. The pH of the coating composition was 5.0; and

(2) a non pigmented gelatin binder layer containing per sq.m 0.7 g of gelatin, 0.066 g of hydroquinone and 0.095 g of matting agent on the basis of silica particles coated with urea formaldehyde resin.

In an analogous way other photographic materials on temporary support but containing magenta, yellow and black pigment coatings were prepared.

The magenta pigment coating was prepared starting with a paste sold under the name HELIOECHTCARMIN BB TEIG (Colour Index Nr. 12,485) and the yellow pigment caoting was prepared starting with a paste sold under the name HELIOECHTGELB GRN 7476 Feinteig (Colour Index Nr. 21,100). Said pigment-pastes were used in an amount of 14.5 g and 17.6 g respectively per liter of coating composition. In the black pigment coating a carbon black paste was incorporated in admixture with the above mentioned FLEXONYL BLUE-paste in an amount of 15.75 g and 1.26 g respectively per liter of coating composition.

- Preparation of the permanent support.

A double-side polyethylene coated paper with paper weight of 180 g/m2 and a polyethylene layer weight of 30 g per m2 was air-knife coated at a wet coverage of 55 g per m2 with the following coating composition :

```
distilled water                                                    300 ml

gelatin                                                            19.8 g

20 % aqueous latex of copoly(methylmethacrylate-butadiene) (50/50)   151 g

aqueous dispersion containing 2.86 % of polymethylmethacrylate and 9.5 %

of gelatin                                                         25.5 g

21.4 % aqueous dispersion of TiO 2 (average grain size 300 nm) containing

5.7 % of gelatin                                                    131 g

matting agent A                                                     5.8 g

matting agent B                                                     2.8 g

wetting agents of the anionic sulphonated type                      2.8 g

as hardening agent a 20 % aqueous solution of formaldehyde          2.2 ml

distilled water up to                                              1000 ml
```

Matting agent A is an aqueous dispersion containing 10.7 % of amorphous silica, 6.4 % of gelatin and 4.3 % of polyethylacrylate latex particles.

Matting agent B is an aqueous dispersion containing 41.8 % of Alpha-quartz and 4.2 % of gelatin.

The weight % of $TiO_2$ with respect to the total layer composition was 29.5 in the dried layer. The coverage of $TiO_2$ was 1.54 g/m2.

-Exposure.

The photographic layers on their temporary support were scanningwise halftone exposed on a commercial argon ion laser scanner operating with electronic dot generation.

The four photographic materials containing the differently pigmented coatings, having DIN A4 format, were exposed successsively for obtaining the corresponding colour separations (yellow, magenta, cyan and optionally black).

- Transfer.

In the exposed state first the cyan pigment containing multilayer structure was transferred onto the permanent support as described hereinbefore by soaking the permanent support in water for 10 s and then pressing it into contact with layer (2). By stripping apart the temporary support the composite layer structure of layers (1) and (2) was left on the permanent support and the transferred composite layer was dried.

- Hardening development.

The transferred composite coating was hardening developed by dipping it for 30 s in an aqueous liquid, called activator bath, having following composition :

| potassium hydroxide | 25 g |
|---|---|
| potassium carbonate | 150 g |
| potassium bromide | 0.5 g |
| sodium sulphite | 2.0 g |
| 4(hydroxymethyl)4-methyl-1-phenyl-3-pyrazolidinone | 5.0 g |
| mono sodium salt of ethylenediaminetetra-acetic acid | 1.0 g |

- Bleach-fixing

The developed material was led through a bleach-fix bath containing sodium thiosulphate and the mono sodium,iron(III) salt of ethylenediamine tetra-acetic acid.

- Wash-off processing.

To obtain a cyan coloured relief image the hardening developed and bleach-fix processed material was wash-off processed with a warm (40 °C) water spray. The relief image was dried.

For obtaining a multi-colour relief image the described magenta, yellow and black pigment coatings were exposed and processed analogously to form in consecutive order superposed relief paterns on the same permanent support already containing the cyan image.

- Preparation of the stripping film material.

Onto a cellulose triacetate support having a thickness of 190 $\mu$m was coated at a wet coating thickness of 150 g/m$^2$ the following coating composition for forming anti-abrasion, gloss improving layer (i) :

| nitrocellulose (DS : 2.25) | 26 g |
|---|---|
| methanol | 335 ml |
| ethanol | 365 ml |
| diethyl ether | 250 ml |
| n-propanol | 50 ml |

After drying onto layer (i) the following coating composition for forming subbing layer (ii) was coated at a coverage sufficient to form a dry layer having a thickness of 0.7 $\mu$m :

| water | 30 ml |
|---|---|
| gelatin | 12 g |
| maleic acid | 1 g |
| butanol | 200 ml |
| methyl ethyl keton | 370 ml |
| ethanol | 400 ml |
| nitrocellulose (DS : 2.25) | 7.5 g |

Onto the dried subbing layer an adhesive layer (iii) was applied at a wet coverage of 50g/m$^2$ from the following coating composition :

| water | 800 ml |
|---|---|
| gelatin | 40 g |
| matting agent A | 10 g |
| DARATAK 74L (registered trade name) | 50 ml |
| wetting agent solution W1 | 15 ml |
| wetting agent solution W2 | 30 ml |
| water up to | 1000 ml |

Matting agent A is an aqueous dispersion containing 3 % of polymethylmethacrylate particles of average particle size 4 $\mu$m and 10 % of gelatin.

Wetting agent solution W1 is a 10 % solution of saponine in methanol/water (1/1 by volume).

Wetting agent solution W2 is a 2 % solution of ULTRAVON W (registered trade mark of CIBA A.G. -Switzerland) [disodium salt of heptadecylbenzimidazole disulphonic acid] in a mixture methanol/water (1/2 by volume).

- Transfer of the strippable layer assemblage

The transfer of the layer assemblage of layers (i), (ii) and (iii) with the side of layer (iii) directed towards the obtained multicolour relief image was carried out in an apparatus as schematically represented in Figure 3. Through the entrance opening 1 of said apparatus the multicolour relief image on permanent support was introduced with the relief image directed upwardly. In the tray corresponding with entrance opening 1 plain water was present as shown in the drawing and the multicolour image was conveyed therethrough while simultaneously the above prepared stripping film material with its layer (iii) directed downwardly was introduced through entrance opening 2 and conveyed through the dry tray.

At the exit side of the apparatus the wetted multicolour relief image was brought into contact with the dry stripping film material and conveyed through the nip of a pair of pressure rollers 3 and 4 pressing the wetted relief image parts against layer (iii) of the stripping film material. After being pressed together the materials were left in contact for 2 minutes in a hot air stream of 55 °C. From the layer assemblage of layers (i), (ii) and (iii) the temporary cellulose triacetate support was stripped off. Such proceeded by making first at one border side an incision in the temporary support which on plying was fractured and easily peeled off from said layer assemblage. As a result of said procedure the multicolour relief image was covered with an outermost anti-abrasion, gloss improving layer.

The reflectance in the white portions of the image covered by said gloss improving layer was measured according to DIN standard No. 67 530 (November 1972) (measuring angle 20°) and corresponded with 68 % reflectance. In the absence of said gloss improving layer the reflectance reached only 11 %.

The increase in dot gain ($\Delta$DG) was determined and found to be 5 %. The dot gain was measured with respect to the dots in the halftone original at 50 % dot value.

The halftone dot area percentage was calculated with the Murray-Davies equation (ref. Murray A., "Monochrome Reproduction in Photoengraving", J. Franklin Institute, vol. 221, p. 721-744, reading as follows :

$$a = \frac{1 - 10^{-D_t}}{1 - 10^{-D_s}} \times 100$$

wherein :
$D_t$ represents the density of the halftone tint,
$D_s$ represents the density of the solid, and
a represents the halftone dot area percentage.
The dot gain is obtained by subtracting the dot area percentage of the original halftone separation image from the above calculated one obtained on the colour proof material provided with gloss improving anti-abrasion layer.

## Claims

1. A process for improving the resistance to mechanical damage of an image formed by coloured hydrophilic colloid layer relief parts on a permanent support or of an image present in a hydrophilic colloid layer on a permanent support and controlling the visual appearance of said image which comprises the following steps :

   (1) providing a stripping film material consisting of a temporary support coated with a layer assemblage of :

      (i) an undermost 1 to 15 $\mu$m thick water-insoluble layer essentially consisting of a nitrocellulose having a substitution degree (DS) in the range of 2 to 2.5, or essentially consisting of a mixture of such a nitrocellulose with an ethyl cellulose having a substitution degree (DS) in the range of 2.2 to 2.6, wherein the weight ratio of the nitrocellulose to the ethyl cellulose is in the range from 60/40 to 95/5,

      (ii) a 0.1 to 1.5 $\mu$m thick layer of a mixture of gelatin, maleic acid and a nitrocellulose as defined above, wherein the gelatin is present in a weight percentage of at least 40, the maleic acid is present in a weight percentage between 2.5 and 20, and the nitrocellulose is present in a weight percentage between 20 and 40, and

      (iii) a 0.1 to 5 $\mu$m thick adhesive top layer becoming sticky when moistened with water and containing unhardened gelatin up to at least 25 % by weight and dispersed polymer particles that have a glass transition temperature (Tg) lower than 0 °C and improve the sticking power of layer (iii) towards a moist gelatin layer,

   (2) pre-wetting with water said coloured hydrophilic colloid layer relief parts or said hydrophilic colloid layer containing an image,

   (3) laminating the stripping film to the pre-wetted image side by pressing it with said gelatin containing layer (iii) against the coloured hydrophilic colloid layer relief parts or the hydrophilic colloid layer containing an image on their permanent support, and

   (4) stripping off the temporary support to leave the assemblage of said layers (i), (ii) and (iii) covering the imaging material on said permanent support, layer (i) forming an outermost anti-abrasion layer.

2. Process according to claim 1, wherein layer (i) has a thickness of 5 $\mu$m and the weight ratio of said nitrocellulose to said ethyl cellulose is 85/15.

3. Process acording to claim 1 or 2, wherein the temporary support of said stripping film material is a cellulose triacetate support.

4. Process according to any of claims 1 to 3, wherein in layer (iii) said dispersed polymer particles have a glass transition temperature below minus 10 °C.

5. Process according to any of the preceding claims, wherein the gloss of the protected image is controlled by incorporating finely divided organic polymer particles and/or inorganic pigment particles in layer (i).

6. Process according to any of the preceding claims, wherein the transfer of the layer assemblage of layers (i), (ii) and (iii) proceeds to a multicolour halftone image obtained by a wash-off processing.

7. Process according to claim 6, wherein said multicolour halftone image has been prepared by the following steps :

   (1) transferring a substantially non-hardened gelatin silver halide emulsion layer containing coloured pigment particles dispersed therein from a temporary support onto a permanent support being a paper base support which support may carry already a halftone relief image containing coloured hardened gelatin,

   (2) imagewise exposing the non-hardened gelatin silver halide emulsion layer prior to or after carrying out said step (1),

   (3) forming by hardening development a halftone image in said transferred silver halide emulsion layer,

   (4) removing selectively unhardened portions of the transferred layer by wash-off processing, and

   (5) repeating steps (1), (2), (3) and (4) to form at least partly superposed portions of differently coloured gelatin containing layers.

8. A stripping film material consisting of a temporary support coated with a layer assemblage of (i) an undermost 1 to 15 μm thick water-insoluble layer essentially consisting of a nitrocellulose having a substitution degree (DS) in the range of 2 to 2.5, or essentially consisting of a mixture of such a nitrocellulose with an ethyl cellulose having a substitution degree (DS) in the range of 2.2 to 2.6, wherein the weight ratio of the nitrocellulose to the ethyl cellulose is in the range from 60/40 to 95/5,
(ii) a 0.1 to 1.5 μm thick layer of a mixture of gelatin, maleic acid and a nitrocellulose as defined above, wherein the gelatin is present in a weight percentage of at least 40, the maleic acid is present in a weight percentage between 2.5 and 20, and the nitrocellulose is present in a weight percentage between 20 and 40, and
(iii) a 0.1 to 5 μm thick adhesive layer becoming sticky when moistened with water and containing unhardened gelatin up to at least 25 % by weight and dispersed polymer particles that have a glass transition temperature (Tg) lower than 0 °C and improve the sticking power of layer (iii) towards a moist gelatin layer.

9. A stripping film material according to claim 8, wherein layer (i) has a thickness of 5 um and the weight ratio of said nitrocellulose to said ethyl cellulose is 85/15.

10. A stripping film material according to claim 8 or 9, wherein said temporary support is a cellulose triacetate support.

11. A stripping film material according to any of claims 8 to 10, wherein in said layer (ii) the dispersed polymer particles have a glass transition temperature below minus 10 °C.

12. A stripping film material according to claim 11, wherein the dispersed polymer particles are made of a copoly(vinyl acetate-acrylate ester-methacrylic acid) in which the content of methacylic acid units is in the range of 0.5 to 5 mol % and the Tg = -18 °C.

FIG. 1

EP 0 462 330 A1

EP 0 462 330 A1

FIG. 2

FIG. 3

European
Patent Office

**EUROPEAN SEARCH
REPORT**

Application Number

**EP 90 20 1630**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A,D | EP-A-0 324 192 (AGFA)<br>* whole document *<br>- - - | 1,5-7 | G 03 C 11/12<br>G 03 C 1/76 |
| A | GB-A-1 047 701 (GEVAERT PHOTO-PRODUCTEN)<br>* whole document *<br>- - - | 1-3,8-11 | |
| A | FR-A-9 890 32 (M. GARGARI)<br>* whole document; in particular: claim 5 *<br>- - - | 8 | |
| A | DE-A-3 709 818 (DU PONT)<br>* whole document *<br>- - - - - | 4,5 | |
| | | | **TECHNICAL FIELDS SEARCHED (Int. Cl.5)**<br><br>G 03 C 1/00<br>G 03 F 3/00<br>G 03 C 11/00 |

The present search report has been drawn up for all claims

| Place of search | Date of completion of search | Examiner |
|---|---|---|
| Berlin | 20 December 90 | STOCK H |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons

 

& : member of the same patent family, corresponding
    document